# EUROPEAN PATENT SPECIFICATION

(11) **EP 4 173 454 B1**
(45) Date of publication and mention of the grant of the patent: **19.03.2025**
(21) Application number: 21740414.4
(22) Date of filing: 24.06.2021
(51) Int. Cl.: H05K 7/20

(54) **SYSTEMS AND METHODS OF IMPROVING THERMAL MANAGEMENT OF HEAT-GENERATION COMPONENTS**
SYSTEME UND VERFAHREN ZUR VERBESSERUNG DER WÄRMEVERWALTUNG VON WÄRMEERZEUGUNGSKOMPONENTEN
SYSTÈMES ET PROCÉDÉS POUR L'AMÉLIORATION DE LA GESTION THERMIQUE DE COMPOSANTS GÉNÉRANT DE LA CHALEUR

(30) Priority: 25.06.2020 NL 2025918
(43) Date of publication of application: 03.05.2023
(73) Proprietor: Microsoft Technology Licensing, LLC, Redmond, WA 98052 (US)
(72) Inventor: SHAW, Mark Edward, Redmond, Washington 98052 (US); ALISSA, Husam Atallah, Redmond, Washington 98052 (US); LANKSTON, Robert Jason, Redmond, Washington 98052 (US); RUBENSTEIN, Brandon Aaron, Redmond, Washington 98052 (US)
(74) Representative: Murgitroyd & Company
(86) International application number: PCT/US2021/038973
(87) International publication number: WO 2021/263037

(56) References cited:
- US-A1- 2010 328 889
- US-A1- 2013 105 122
- US-A1- 2014 082 942
- US-A1- 2014 123 492
- US-A1- 2015 109 735
- US-A1- 2016 073 548
- US-A1- 2019 269 004
- US-A1- 2019 279 916

## Description

### BACKGROUND

### Background and Relevant Art

Computing devices can generate a large amount of heat during use. The computing components can be susceptible to damage from the heat and commonly require cooling systems to maintain the component temperatures in a safe range during heavy processing or usage loads. Liquid cooling can effectively cool components as liquid cooling fluids have more thermal mass than air or gas cooling. The liquid cooling fluid can be maintained at a lower temperature by allowing vaporized fluid to rise out of the liquid. The vapor in the cooling liquid can adversely affect the cooling performance of the cooling fluid. The vapor can be condensed and returned to the boiler tank.

In conventional immersion cooling systems, a large percentage of the boiler tank contains cooling fluid that functioning as a heat sink and is not efficiently removing heat from the system through boiling. High costs are associated with obtaining, containing, and maintaining the additional cooling fluid despite the relatively low efficiency of its inclusion in the boiler tank.
US 2015/0109735 A1 relates to a substrate on which are positioned electronic components to be cooled.
US 2010/0328889 A1 relates to a cooled electronic module having a casing.
US 2019/0269004 A1 relates to a circulating path for a coolant formed inside a heat-radiating function equipped lid portion.
US 2016/0073548 A1 relates to a heat exchange that causes a coolant vaporized in the cooling module mounting board to condense and a coolant circulating pump that sends the coolant after the condensation in the liquid phase to the cooling module mounting board.

### BRIEF SUMMARY

According to the invention, there is provided a computer system and a server computer system in accordance with the claims. The dependent claims provide further optional features.

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

Additional features and advantages will be set forth in the description which follows, and in part will be obvious from the description, or may be learned by the practice of the teachings herein. Features and advantages of the disclosure may be realized and obtained by means of the instruments and combinations particularly pointed out in the appended claims. Features of the present disclosure will become more fully apparent from the following description and appended claims or may be learned by the practice of the disclosure as set forth hereinafter.

### BRIEF DESCRIPTION OF THE DRAWINGS

In order to describe the manner in which the above-recited and other features of the disclosure can be obtained, a more particular description will be rendered by reference to specific embodiments thereof which are illustrated in the appended drawings. For better understanding, the like elements have been designated by like reference numbers throughout the various accompanying figures. While some of the drawings may be schematic or exaggerated representations of concepts, at least some of the drawings may be drawn to scale. Understanding that the drawings depict some example embodiments, the embodiments will be described and explained with additional specificity and detail through the use of the accompanying drawings in which:
FIG. 1 is a system diagram of a conventional immersion cooling system;
FIG. 2 is a perspective view of an immersion cooling system, according to at least one embodiment of the present disclosure;
FIG. 3 is a side cross-sectional view of a multi-chip module in a boiler tank according to at least one embodiment of the present disclosure;
FIG. 4 is a top view of a multi-chip module in a boiler tank, according to at least one embodiment of the present disclosure;
FIG. 5 is a perspective view of a computing device board including a plurality of boiler tanks, according to at least one embodiment of the present disclosure;
FIG. 6 is a detail perspective view of a boiler tank of FIG. 5, according to at least one embodiment of the present disclosure;
FIG. 7 is a perspective view of a boiler tank with a liquid-cooled condenser, according to at least one embodiment of the present disclosure;
FIG. 8 is a perspective view of a computing device with a plurality of boiler tanks in fluid communication with a condenser, according to at least one embodiment of the present disclosure; and
FIG. 9 is a side cross-sectional view of a boiler tank including passive atmospheric cooling, according to at least one embodiment of the present disclosure.

### DETAILED DESCRIPTION

The present disclosure relates generally to systems and methods for improving the thermal management of high heat-generation components. More particularly, the present disclosure relates to using localized liquid immersion cooling to cool one or more computer components on a substrate within a larger board of a computing device.

Immersion cooling systems surround the heat-generating components in a liquid cooling fluid, which conducts heat from the heat-generating components to cool the heat-generating components. As the cooling fluid absorbs heat from the heat-generating components, the temperature of the cooling fluid increases and the cooling fluid may vaporize, introducing vapor into the liquid of the cooling fluid, which then rises out of the liquid. The vapor, thereby, removes heat from the cooling fluid near the heat-generating components.

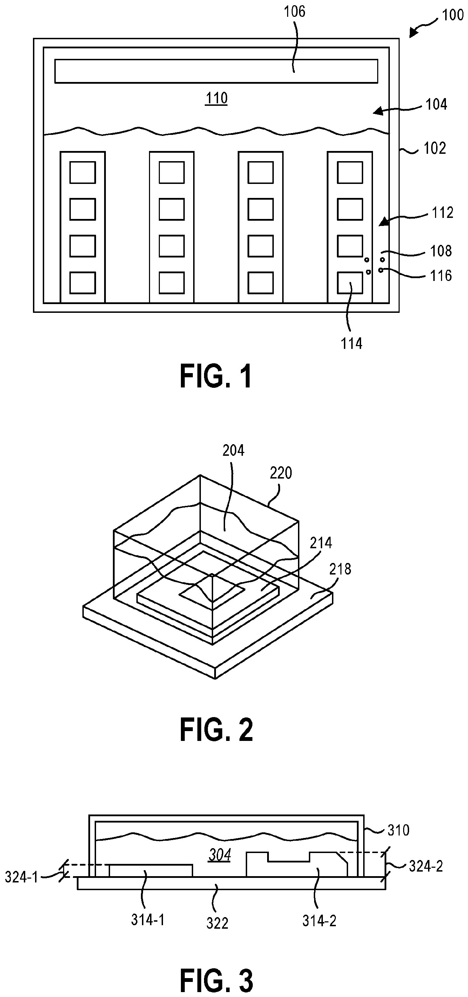

Referring now to FIG. 1, an immersion cooling system 100 according to the present disclosure includes a chamber 102 with a cooling fluid 104 positioned therein. A condenser 106 is positioned at the top of the cooling fluid 104 above the liquid cooling fluid 108 and in a vapor 110 of the cooling fluid 104. The condenser 106 cools part of the vapor 110 of the cooling fluid 104 back into a liquid phase, removing thermal energy from the system and reintroducing the cooling fluid 104 into the immersion bath 112 of the liquid cooling fluid 108.

In some embodiments, the immersion bath 112 of the liquid cooling fluid 108 has a plurality of heat-generating components 114 positioned in the liquid cooling fluid 108. The liquid cooling fluid 108 surrounds the heat-generating components 114 and may surround other objects or parts attached to the heat-generating components 114.

As described, conversion of the liquid cooling fluid 108 to a vapor phase 116 requires the input of thermal energy to overcome the latent heat of vaporization and may be an effective mechanism to increase the thermal capacity of the cooling fluid and remove heat from the heat-generating components 114.

The cooling fluid transitions between a liquid phase and a vapor phase to remove heat from hot or heat-generating components in the chamber. The liquid phase more efficiently receives heat from the components and, upon transition to the vapor phase, the cooling fluid can be cooled and condensed to extract the heat from the cooling fluid before the cooling fluid is returned to the liquid immersion bath at a lower temperature.

In some embodiments, the immersion bath of the liquid cooling fluid 108 has a plurality of heat-generating components 114 positioned in the liquid cooling fluid 108. The liquid cooling fluid 108 surrounds the heat-generating components 114 and other objects or parts attached to the heat-generating components 114. In some embodiments, one or more of the heat-generating components 114 includes a heat sink or other device attached to the heat-generating component 114 to conduct away thermal energy and effectively increase the surface area of the heat-generating component 114.

Because the vapor phase 116 rises in the liquid cooling fluid 108, the vapor phase 116 can be extracted from the immersion chamber 102 in an upper vapor region 110 of the chamber 102. A condenser 106 cools part of the vapor of the cooling fluid 104 back into a liquid phase, removing thermal energy from the system and reintroducing the cooling fluid into the immersion bath 112 of the liquid cooling fluid 108. The condenser 106 radiates or otherwise dumps the thermal energy from the cooling fluid 104 into the ambient environment or into a conduit to carry the thermal energy away from the cooling system 100.

In some embodiments, the cooling fluid receives heat in a cooling volume of cooling fluid immediately surrounding the heat-generating components. The cooling volume is the region of the cooling fluid (including both liquid and vapor phases) that is immediately surrounding the heat-generating components and is responsible for the convective cooling of the heat-generating components. In some embodiments, the cooling volume is the volume of cooling fluid within 5 millimeters (mm) of the heat-generating components.

The cooling fluid has a boiling temperature below a critical temperature at which the heat-generating components experience thermal damage. For example, the heat-generating components may be computing components that experience damage above 100° Celsius (C). In some embodiments, the boiling temperature of the cooling fluid is less than a critical temperature of the heat-generating components. In some embodiments, the boiling temperature of the cooling fluid is less than about 90° C. In some embodiments, the boiling temperature of the cooling fluid is less than about 80° C. In some embodiments, the boiling temperature of the cooling fluid is less than about 70° C. In some embodiments, the boiling temperature of the cooling fluid is less than about 60° C. In some embodiments, the boiling temperature of the cooling fluid is at least about 35° C. In some embodiments, the cooling fluid includes water. In some embodiments, the cooling fluid includes glycol. In some embodiments, the cooling fluid includes a combination of water and glycol. In some embodiments, the cooling fluid is an aqueous solution. In some embodiments, the cooling fluid is an electronic liquid, such as FC-72 available from 3M, or similar non-conductive fluids. In some embodiments, the heat-generating components, boiler tank surfaces, or other elements of the immersion cooling system positioned in the cooling fluid have nucleation sites on a surface thereof that promote the nucleation of vapor bubbles of the cooling fluid at or below the boiling temperature of the cooling fluid.

Large immersion cooling systems require a portion of the immersion bath volume to be cooling fluid that is outside of the cooling volume and, therefore, inefficiently cooling the heat-generating components. In some embodiments, not all components of the computing device generate enough heat to need immersion cooling to remain in a safe operating temperature range. In some embodiments, a graphical processing unit (GPU) generates more heat than a platen-based storage device, and ambient air cooling is sufficient to cool the storage device but not the GPU.

In some embodiments, a computing device includes a substrate with a heat-generating component located on the substrate. Some heat-generating components may generate more heat than surrounding components on the same board of the computing device, and a local immersion cooling system may be positioned on or around the heat-generating computer component to provide additional cooling without immersing the entire computing device or board of the computing device.

FIG. 2 is a perspective view of an embodiment of a heat-generating component 214 located on a substrate 218. A boiler tank 220 is affixed to the substrate 218 to enclose the heat-generating component 214. The boiler tank 220 contains cooling fluid 204 that receives heat from and cools the heat-generating component 214. In some embodiments, the boiler tank 220 is connected directly to the substrate 218, such that the substrate contributes to containing the cooling fluid 204.

In some embodiments, a local immersion cooling system allows more efficient cooling of the heat-generating component(s) that generates the greater amount of heat without requiring the cost and complexity of an immersion cooling system that is large enough to support the entire computing device. In some embodiments, a local immersion cooling system allows for more efficient cooling of components with complex topographies to which it is difficult to attach a conventional heat sink. In some embodiments, a local immersion cooling system allows for more efficient cooling of components that are positioned close to one another, to which it is difficult to attach conventional heat sinks due to the close proximity of the components and the volume required by a conventional heat sink.

In some embodiments, the local immersion cooling system includes a boiler tank that is smaller than the board of the computing device. In some embodiments, the boiler tank has a tank area (e.g., a bottom area of the tank) that is approximately the same area as the substrate of the heat-generating computer component. In some embodiments, the tank area is the same area as the substrate of the heat-generating computer component. In some embodiments, the substrate of the heat-generating computer component is the bottom surface of the boiler tank and the boiler tank attaches directly to a perimeter edge of the substrate.

In some embodiments, a multi-chip module (MCM) is located on a substrate, and the substrate for the MCM is affixed to a board for the computing device. A MCM includes a plurality of electronic components on a single substrate to facilitate efficient energy usage and improve communication bandwidth between the components. As used herein, a MCM may be considered a single heat-generating component, according to some embodiments of the present disclosure. In some embodiments, a MCM has a first component with a first height above the substrate and a second component with a different second height above the substrate. For example, the first component is taller than the second component relative to the substrate of the MCM. A conventional heat sink applied to both the first component and second component would, therefore, need to compensate for the differences in height and/or topography of the two components of the MCM. In other examples, a heat transfer element could be positioned between the heat sink and the shorter of the two components. Each interface between materials and each layer of thermal interface material (TIM) increases the thermal resistance and, hence, inefficiency of the thermal management system.

FIG. 3 is a side view of an embodiment of a computing device board 322 with a first heat-generating component 314-1 and a second heat-generating component 314-2 thereon. The first heat-generating component 314-1 has a first height 324-1 and second heat generating component 314-2 has a second height 324-2. The cooling fluid 304 contained in the boiler tank 310 flows around the topography of the first heat-generating component 314-1 and second heat-generating component 314-2 irrespective of their relative heights, shapes, geometries, or surface textures. While conventional components have smooth top surfaces facilitate thermal conductivity to a rigid conductive heat sink, immersion cooling systems according to the present disclosure can efficiently cool components with any geometries or combinations of geometries.

In some embodiments according to the present disclosure, an immersion cooling system for a MCM or other plurality of components on a substrate having different heights can limit and/or eliminate intermediate interfaces that reduce the efficiency of the thermal management system. In some embodiments, the first component and the second component are submerged in the liquid cooling fluid with no additional TIM therebetween. The liquid cooling fluid, therefore, provides a more efficient thermal path to remove heat from both the first component and the second component than a conventional heat sink(s) with one or more layers of TIM.

In some embodiments, a first component and a second component are positioned close to one another, and individual conventional heat sinks cannot be positioned on both the first component and the second component without interfering with one another. An immersion cooling system according to some embodiments of the present disclosure submerge the first component and second component in the liquid cooling fluid and the cooling fluid functions as the heat sink to remove heat from the components. Additionally, the first and second components may produce different amounts of heat at difference conditions, and any heat sink affixed to the components must be sufficient to cool the components under a high operating load, even if that operating load is uncommon. 2-phase immersion cooling can provide a more flexible cooling system that adapts to the amount of heat generated by the components.

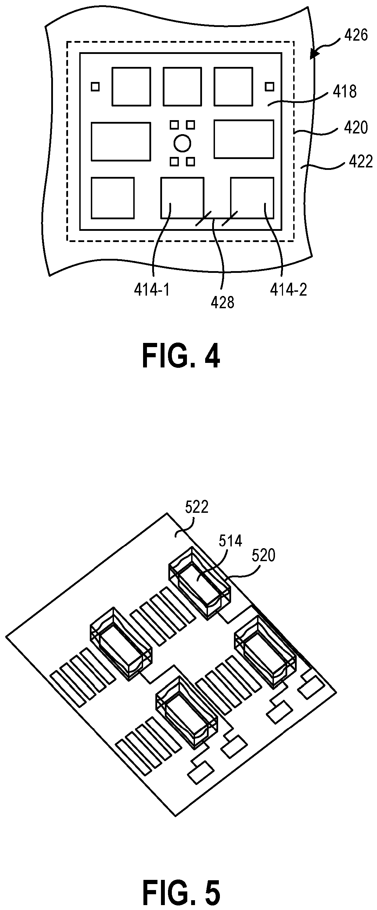

FIG. 4 is a top view of an embodiment of a MCM 426 on a board 422. The MCM 426 has a plurality of heat-generating components 414-1, 414-2 positioned on a substrate 418 with a boiler tank 420 affixed to the board 422 encompassing the substrate 418 and the heat-generating components of the MCM 426. In some embodiments, a first heat-generating component 414-1 and second heat-generating component 414-2 are located adjacent to one another on the substrate 418 and would be too close to one another for a conventional rigid or solid heat sink to be affixed to each without interfering with the other heat sink. In some embodiments, a lateral spacing 428 between the first heat-generating component 414-1 and second heat-generating component 414-2 is less than 10 millimeters. In some embodiments, a lateral spacing 428 between the first heat-generating component 414-1 and second heat-generating component 414-2 is less than 5 millimeters.

In some embodiments, not all components on a board require an immersion cooling system to maintain the components in a safe operating temperature range. In some embodiments, a board has a plurality of components positioned thereon, and a boiler tank is positioned on the board to surround at least one component of the plurality of components.

FIG. 5 is a perspective view of a computing device board 522 with a plurality of heat generating components 514 thereon. A plurality of boiler tanks 520 are positioned on the board 522, but only encompass some of the heat-generating components 514. In some embodiments, a MCM is contained within a boiler tank 520, while other components, such as storage devices are located outside of the boiler tanks 520.

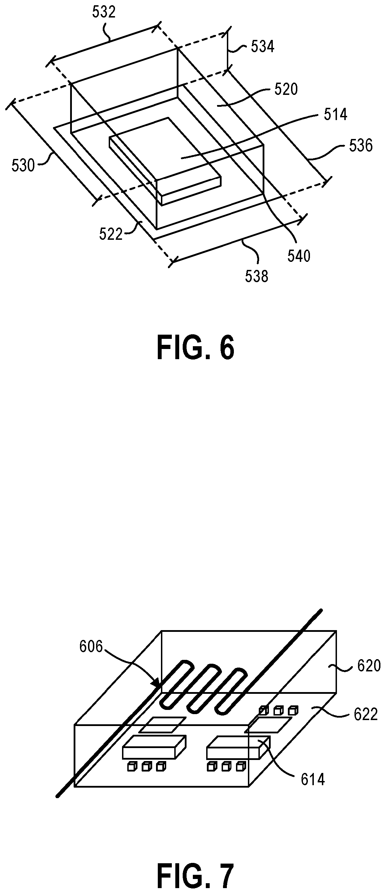

Referring now to FIG. 6, in some embodiments, the boiler tank 520 has a tank length 530, tank width 532, and tank height 534 that define a tank volume. The tank length 530 and tank width 532 define a tank area. In some embodiments, the board 522 has a board length 536 and board width 538 that define a board area. In some embodiments, at least one component encompassed by the boiler tank is built upon a substrate. In some embodiments, the substrate has a similar substrate length and substrate width that define a substrate area.

In some embodiments, the tank area is the same as the board and/or substrate area. In some embodiments, the tank area is at least 10% less than the board and/or substrate area. For example, the tank area is less than 90% of the board and/or substrate area. In some embodiments, the tank area is less than 75% of the board and/or substrate area to allow at least a portion of the components of the board and/or substrate to be positioned outside of the boiler tank.

In some embodiments, a heat-generating component positioned on the board is located on a substrate. In some embodiments, the tank area is no more than 50% of a substrate area of the substrate. In some embodiments, the tank area is substantially equal to the substrate area. In some embodiments, the tank area is less than the substrate area. In some embodiments, the tank area is less than 90% of the substrate area, as there is conventionally a border around the component on the substrate upon which the component is assembled. In some embodiments, the board and/or substrate has holes therein to allow the board and/or substrate to connect to another structure. The tank area may be less than the board area and/or substrate area because the tank is positioned to allow access to the holes of the board and/or substrate.

In some embodiments, at least a portion of the board and/or substrate forms a wall of the boiler tank. Referring again to FIG. 6, the boiler tank 520 is connected directly to the board 522, sealing an immersion chamber that includes a portion of the board 522 as a wall of the chamber. In some embodiments, at least a portion of the board and/or substrate is integral to the boiler tank and holds the cooling fluid in the boiler tank. In some embodiments, the board and/or substrate upon which the boiler tank is positioned has an O-ring 540 positioned thereon that facilitates a liquid-tight seal between the board and/or substrate and the boiler tank. In some embodiments, the O-ring 540 follows at least a portion of a perimeter edge of the board and/or substrate. In some embodiments, the O-ring 540 follows the entire perimeter edge of the board and/or substrate. In some embodiments, the O-ring 540 is affixed to the boiler tank 520, such that when the boiler tank 520 is placed in contact with the board and/or substrate, the O-ring 540 seals the contact area between the boiler tank 520 and the board and/or substrate.

The boiler tank according to some embodiments of the present disclosure includes a cooling mechanism to condense vapor cooling fluid to a liquid phase and remove heat from the boiler tank. In some embodiments, the boiler tank includes or is in fluid communication with a condenser. In some embodiments, the condenser is a liquid-cooled condenser that cycles a second fluid (e.g., water) through the condenser to transfer heat from the condenser and cool the cooling fluid. In some embodiments, the condenser is a solid-state condenser, such as a Peltier cooler, that cools and condenses the cooling fluid.

In some embodiments, the condenser is located in the boiler tank. In some embodiments, the condenser is located outside of the boiler tank and is in fluid communication with the immersion chamber of the boiler tank to cool and condense the vapor cooling fluid. In some embodiments, the condenser is located outside of the boiler tank and cools a surface of the boiler tank to cool and condense the vapor cooling fluid.

FIG. 7 is a perspective view of an embodiment of a board 622 with a plurality of heat-generating components 614 thereon with a boiler tank 620 affixed over the plurality of heat-generating components 614. The boiler tank 620 has a condenser 606 positioned on a surface thereof, that circulates water through coils to cool and condense the cooling fluid in the boiler tank 620.

In some embodiments, a plurality of boiler tanks is in fluid communication with a single condenser. For example, a condenser may be connected to and in fluid communication with a plurality of boiler tanks on a single board. In some embodiments, a condenser may be connected to and in fluid communication with a plurality of boiler tanks on different boards.

In some embodiments, a board and/or substrate has a plurality of boiler tanks positioned thereon. The boiler tanks are positioned to provide immersion cooling to different components of the board and/or substrate, such as a first boiler tank covering and providing immersion cooling to a MCM and a second boiler tank covering and providing immersion cooling to a network switch. In some embodiments, the plurality of boiler tanks shares cooling fluid between the boiler tanks of the plurality of boiler tanks. In some embodiments, each boiler tank of the plurality of boiler tanks has dedicated cooling fluid that does not mix with another boiler tank.

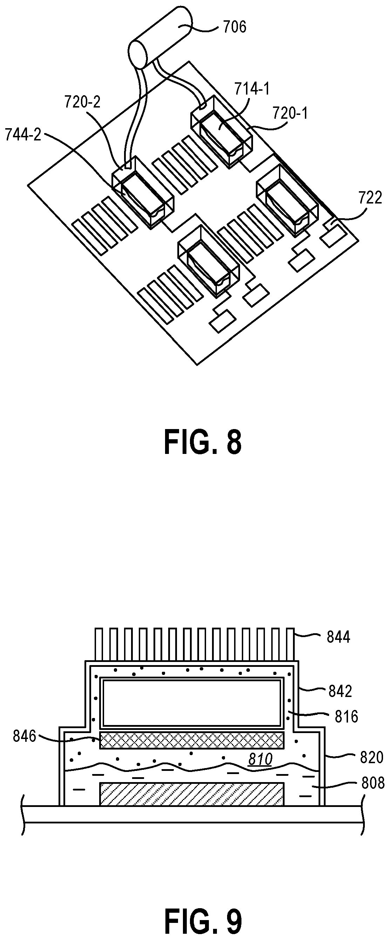

FIG. 8 is a perspective view of another embodiment of a board 722 with a plurality of boiler tanks 720 thereon. Each of the boiler tanks 720 encloses at least one heat-generating component 714-1, 714-2, and at least two of the plurality of boiler tanks 720 are in fluid communication with a condenser 706. The boiler tanks 720-1, 720-2 that are in fluid communication with the condenser 706 share cooling fluid therebetween. In some embodiments, some of the boiler tanks 720-1, 720-2 are in fluid communication with a condenser 706, and some of the boiler tanks are not.

In some embodiments, a board and/or substrate with a plurality of boiler tanks thereon has a total tank area relative to the board area and/or substrate area. The total tank area is the summation of the tank area of each boiler tank of the plurality of boiler tanks. A computing device with two boiler tanks on a board, where each boiler tank has a tank area that is 10% of the board area, has a total tank area that is 30% of the board area. A MCM assembled on a substrate with two boiler tanks on the substrate, where a first boiler tank has a first tank area that is 50% of the substrate area and a second boiler tank has a second tank area that is 20% of the substrate area, has a total tank area that is 70% of the substrate area. For example, the four boiler tanks of FIG. 8 have a total tank area of approximately 10% of the board area.

In some embodiments, the total tank area is the same as the board and/or substrate area. In some embodiments, the total tank area is at least 10% less than the board and/or substrate area. For example, the total tank area is less than 90% of the board and/or substrate area. In some embodiments, the total tank area is less than 75% of the board and/or substrate area to allow at least a portion of the components of the board and/or substrate to be positioned outside of the plurality of boiler tanks.

As described herein, some embodiments of immersion cooling systems according to the present disclosure include a condenser with active cooling, such as liquid cooling or solid-state cooling. In some embodiments, an immersion cooling system or a boiler tank of an immersion cooling system uses atmospheric cooling to dissipate heat from the cooling fluid. In some embodiments, the liquid cooling fluid can provide efficient heat transfer from heat-generating components with different or varying topographies, while the cooling fluid itself transfers the heat to fins, heat pipes, vapor chambers, heat sinks, or other passive cooling devices to be cooled by atmospheric cooling.

In some embodiments, the boiler tank of the immersion cooling system has a passive cooling device affixed thereto. In some embodiments, the passive cooling device includes heat fins to conduct heat from the boiler tank and to increase surface area exposure to the ambient air and remove heat from the boiler tank. In some embodiments, the passive cooling device includes a heat pipe or vapor chamber to disperse and/or conduct heat from the boiler tank to another area or to increase surface area exposure to the ambient air and remove heat from the boiler tank. In some embodiments, the passive cooling device is used in conjunction with or in addition to an active cooling device.

FIG. 9 is a side view of an embodiment of a boiler tank 820 according to the present disclosure with a heat pipe 842 and heat fins 844 positioned on a top surface of the boiler tank 820. In some embodiments, the boiler tank 820 has sufficient surface area to allow atmospheric cooling of the vapor phase 816 in the heat pipe 842 to return the vapor phase 816 to the liquid cooling fluid 808 around the heat-generating component 814.

In some embodiments, boiling cooling fluid and the associated increase in vapor in the boiler tank increases that vapor pressure in the boiler tank. As the condenser or other cooling device cools the vapor to condense the vapor phase back into the liquid phase, the boiler tank may need to sustain increased vapor pressure without rupturing. In some embodiments, the boiler tank can sustain at least 2.0 atmospheres of internal vapor pressure. In some embodiments, the boiler tank can sustain at least 3.0 atmospheres of internal vapor pressure. In some embodiments, the boiler tank can sustain at least 4.0 atmospheres of internal vapor pressure.

To enhance boiling and facilitate return of the cooling fluid to the boiling surface, some embodiments of boiler tanks according to the present disclosure include wicking or boiling enhancement structures located inside the boiler tank in the immersion chamber. In some embodiments, the wicking structure includes an open lattice structure such as sintered copper powder or wire mesh that can enhance boiling efficiency and drive fluid back to the boiling surface using capillary action. In some embodiments, surface etching or boiling enhancement coatings can be applied to the boiling surface to create nucleation sites that enhance boiling efficiency.

Referring again to FIG. 9, in some embodiments, the boiler tank 820 includes a wicking structure 846. The wicking structure 846 is positioned in the vapor portion 810 of the boiler tank 820. The wicking structure 846 may increase the condensation rate and provide sites upon which the vapor phase 816 can condense and return to the liquid cooling fluid 808 more readily.

### INDUSTRIAL APPLICABILITY

The present disclosure relates generally to systems and methods for improving the thermal management of high heat-generation components. More particularly, the present disclosure relates to using localized liquid immersion cooling to cool one or more computer components on a substrate within a larger board of a computing device.

Immersion cooling systems surround the heat-generating components in a liquid cooling fluid, which conducts heat from the heat-generating components to cool the heat-generating components. As the cooling fluid absorbs heat from the heat-generating components, the temperature of the cooling fluid increases and the cooling fluid may vaporize, introducing vapor into the liquid of the cooling fluid, which then rises out of the liquid. The vapor, thereby, removes heat from the cooling fluid near the heat-generating components.

A conventional immersion cooling system includes a boiler tank containing an immersion chamber and a condenser in the immersion chamber. The immersion chamber contains a cooling fluid that has a liquid cooling fluid and a vapor cooling fluid portion. The liquid cooling fluid creates an immersion bath in which a plurality of heat-generating components is positioned to heat the liquid cooling fluid.

The cooling fluid transitions between a liquid phase and a vapor phase to remove heat from hot or heat-generating components in the chamber. The liquid phase more efficient receives heat from the components and, upon transition to the vapor phase, the cooling fluid can be cooled and condensed to extract the heat from the cooling fluid before the cooling fluid is returned to the liquid immersion bath at a lower temperature.

In some embodiments, the immersion bath of the liquid cooling fluid has a plurality of heat-generating components positioned in the liquid cooling fluid. The liquid cooling fluid surrounds the heat-generating components and other objects or parts attached to the heat-generating components. In some embodiments, one or more of the heat-generating components includes a heat sink or other device attached to the heat-generating component to conduct away thermal energy and effectively increase the surface area of the heat-generating component.

As described, conversion of the liquid cooling fluid to a vapor phase requires the input of thermal energy to overcome the latent heat of vaporization and may be an effective mechanism to increase the thermal capacity of the cooling fluid and remove heat from the heat-generating components. Because the vapor rises in the liquid cooling fluid, the vapor phase can be extracted from the chamber in an upper vapor region of the chamber. A condenser cools part of the vapor of the cooling fluid back into a liquid phase, removing thermal energy from the system and reintroducing the cooling fluid into the immersion bath of the liquid cooling fluid. The condenser radiates or otherwise dumps the thermal energy from the cooling fluid into the ambient environment or into a conduit to carry the thermal energy away from the cooling system.

In some embodiments, the cooling fluid receives heat in a cooling volume of cooling fluid immediately surrounding the heat-generating components. The cooling volume is the region of the cooling fluid (including both liquid and vapor phases) that is immediately surrounding the heat-generating components and is responsible for the convective cooling of the heat-generating components. In some embodiments, the cooling volume is the volume of cooling fluid within 5 millimeters (mm) of the heat-generating components.

The cooling fluid has a boiling temperature below a critical temperature at which the heat-generating components experience thermal damage. For example, the heat-generating components may be computing components that experience damage above 100° Celsius (C). In some embodiments, the boiling temperature of the cooling fluid is less than a critical temperature of the heat-generating components. In some embodiments, the boiling temperature of the cooling fluid is less than about 90° C. In some embodiments, the boiling temperature of the cooling fluid is less than about 80° C. In some embodiments, the boiling temperature of the cooling fluid is less than about 70° C. In some embodiments, the boiling temperature of the cooling fluid is less than about 60° C. In some embodiments, the boiling temperature of the cooling fluid is at least about 35° C. In some embodiments, the cooling fluid includes water. In some embodiments, the cooling fluid includes glycol. In some embodiments, the cooling fluid includes a combination of water and glycol. In some embodiments, the cooling fluid is an aqueous solution. In some embodiments, the cooling fluid is an electronic liquid, such as FC-72 available from 3M, or similar non-conductive fluids. In some embodiments, the heat-generating components, boiler tank surfaces, or other elements of the immersion cooling system positioned in the cooling fluid have nucleation sites on a surface thereof that promote the nucleation of vapor bubbles of the cooling fluid at or below the boiling temperature of the cooling fluid.

Large immersion cooling systems require a portion of the immersion bath volume to be cooling fluid that is outside of the cooling volume and, therefore, inefficiently cooling the heat-generating components. In some embodiments, not all components of the computing device generate enough heat to need immersion cooling to remain in a safe operating temperature range. In some embodiments, a graphical processing unit (GPU) generates more heat than a platen-based storage device, and ambient air cooling is sufficient to cool the storage device but not the GPU.

In some embodiments, a computing device includes a substrate with a heat-generating component located on the substrate. Some heat-generating components may generate more heat than surrounding components on the same board of the computing device, and a local immersion cooling system may be positioned on or around the heat-generating computer component to provide additional cooling without immersing the entire computing device or board of the computing device.

In some embodiments, a local immersion cooling system allows more efficient cooling of the heat-generating component(s) that generates the greater amount of heat without requiring the cost and complexity of an immersion cooling system that is large enough to support the entire computing device. In some embodiments, a local immersion cooling system allows for more efficient cooling of components with complex topographies to which it is difficult to attach a conventional heat sink. In some embodiments, a local immersion cooling system allows for more efficient cooling of components that are positioned close to one another, to which it is difficult to attach conventional heat sinks due to the close proximity of the components and the volume required by a conventional heat sink.

In some embodiments, the local immersion cooling system includes a boiler tank that is smaller than the board of the computing device. In some embodiments, the boiler tank has a tank area (e.g., a bottom area of the tank) that is approximately the same area as the substrate of the heat-generating computer component. In some embodiments, the tank area is the same area as the substrate of the heat-generating computer component. In some embodiments, the substrate of the heat-generating computer component is the bottom surface of the boiler tank and the boiler tank attaches directly to a perimeter edge of the substrate.

In some embodiments, a multi-chip module (MCM) is located on a substrate, and the substrate for the MCM is affixed to a board for the computing device. A MCM includes a plurality of electronic components on a single substrate to facilitate efficient energy usage and improve communication bandwidth between the components. As used herein, a MCM may be considered a single heat-generating component, according to some embodiments of the present disclosure. In some embodiments, a MCM has a first component with a first height above the substrate and a second component with a different second height above the substrate. For example, the first component is taller than the second component relative to the substrate of the MCM. A conventional heat sink applied to both the first component and second component would, therefore, need to compensate for the differences in height and/or topography of the two components of the MCM. In other examples, a heat transfer element could be positioned between the heat sink and the shorter of the two components. Each interface between materials and each layer of thermal interface material (TIM) increases the thermal resistance and, hence, inefficiency of the thermal management system.

In some embodiments according to the present disclosure, an immersion cooling system for a MCM or other plurality of components on a substrate having different heights can limit and/or eliminate intermediate interfaces that reduce the efficiency of the thermal management system. In some embodiments, the first component and the second component are submerged in the liquid cooling fluid with no additional TIM therebetween. The liquid cooling fluid, therefore, provides a more efficient thermal path to remove heat from both the first component and the second component than a conventional heat sink(s) with one or more layers of TIM.

In some embodiments, a first component and a second component are positioned close to one another, and individual conventional heat sinks cannot be positioned on both the first component and the second component without interfering with one another. In some embodiments, an immersion cooling system according to the present disclosure submerge the first component and second component in the liquid cooling fluid and the cooling fluid functions as the heat sink to remove heat from the components. Additionally, the first and second components may produce different amounts of heat at difference conditions, and any heat sink affixed to the components must be sufficient to cool the components under a high operating load, even if that operating load is rare. 2-phase immersion cooling can provide a more flexible cooling system that adapts to the amount of heat generated by the components.

In some embodiments, not all components on a board require an immersion cooling system to maintain the components in a safe operating temperature range. In some embodiments, a board has a plurality of components positioned thereon, and a boiler tank is positioned on the board to surround at least one component of the plurality of components. In some embodiments, the boiler tank has a tank length, tank width, and tank height that define a tank volume. The tank length and tank width define a tank area. In some embodiments, the board has a board length and board width that define a board area. In some embodiments, at least one component encompassed by the boiler tank is built upon a substrate. In some embodiments, the substrate has a substrate length and substrate width that define a substrate area.

In some embodiments, the tank area is the same as the board and/or substrate area. In some embodiments, the tank area is at least 10% less than the board and/or substrate area. For example, the tank area is less than 90% of the board and/or substrate area. In some embodiments, the tank area is less than 75% of the board and/or substrate area to allow at least a portion of the components of the board and/or substrate to be positioned outside of the boiler tank.

In some embodiments, a heat-generating component positioned on the board is located on a substrate. In some embodiments, the tank area is no more than 50% of a substrate area of the substrate. In some embodiments, the tank area is substantially equal to the substrate area. In some embodiments, the tank area is less than the substrate area. In some embodiments, the tank area is less than 90% of the substrate area, as there is conventionally a border around the component on the substrate upon which the component is assembled. In some embodiments, the board and/or substrate has holes therein to allow the board and/or substrate to connect to another structure. The tank area may be less than the board area and/or substrate area because the tank is positioned to allow access to the holes of the board and/or substrate.

In some embodiments, at least a portion of the board and/or substrate forms a wall of the boiler tank. In some embodiments, at least a portion of the board and/or substrate is integral to the boiler tank and holds the cooling fluid in the boiler tank. In some embodiments, the board and/or substrate upon which the boiler tank is positioned has an O-ring positioned thereon that facilitates a liquid-tight seal between the board and/or substrate and the boiler tank. In some embodiments, the O-ring follows at least a portion of a perimeter edge of the board and/or substrate. In some embodiments, the O-ring follows the entire perimeter edge of the board and/or substrate.

The boiler tank according to some embodiments of the present disclosure includes a cooling mechanism to condense vapor cooling fluid to a liquid phase and remove heat from the boiler tank. In some embodiments, the boiler tank includes or is in fluid communication with a condenser. In some embodiments, the condenser is a liquid-cooled condenser that cycles a second fluid (e.g., water) through the condenser to transfer heat from the condenser and cool the cooling fluid. In some embodiments, the condenser is a solid-state condenser, such as a Peltier cooler, that cools and condenses the cooling fluid.

In some embodiments, the condenser is located in the boiler tank. In some embodiments, the condenser is located outside of the boiler tank and is in fluid communication with the immersion chamber of the boiler tank to cool and condense the vapor cooling fluid. In some embodiments, the condenser is located outside of the boiler tank and cools a surface of the boiler tank to cool and condense the vapor cooling fluid.

In some embodiments, a plurality of boiler tanks is in fluid communication with a single condenser. For example, a condenser may be connected to and in fluid communication with a plurality of boiler tanks on a single board. In some embodiments, a condenser may be connected to and in fluid communication with a plurality of boiler tanks on different boards.

In some embodiments, a board and/or substrate has a plurality of boiler tanks positioned thereon. The boiler tanks are positioned to provide immersion cooling to different components of the board and/or substrate, such as a first boiler tank covering and providing immersion cooling to a MCM and a second boiler tank covering and providing immersion cooling to a network switch. In some embodiments, the plurality of boiler tanks shares cooling fluid between the boiler tanks of the plurality of boiler tanks. In some embodiments, each boiler tank of the plurality of boiler tanks has dedicated cooling fluid that does not mix with another boiler tank.

In some embodiments, a board and/or substrate with a plurality of boiler tanks thereon has a total tank area relative to the board area and/or substrate area. The total tank area is the summation of the tank area of each boiler tank of the plurality of boiler tanks. A computing device with two boiler tanks on a board, where each boiler tank has a tank area that is 10% of the board area, has a total tank area that is 30% of the board area. A MCM assembled on a substrate with two boiler tanks on the substrate, where a first boiler tank has a first tank area that is 50% of the substrate area and a second boiler tank has a second tank area that is 20% of the substrate area, has a total tank area that is 70% of the substrate area.

In some embodiments, the total tank area is the same as the board and/or substrate area. In some embodiments, the total tank area is at least 10% less than the board and/or substrate area. For example, the total tank area is less than 90% of the board and/or substrate area. In some embodiments, the total tank area is less than 75% of the board and/or substrate area to allow at least a portion of the components of the board and/or substrate to be positioned outside of the plurality of boiler tanks.

As described herein, some embodiments of immersion cooling systems according to the present disclosure include a condenser with active cooling, such as liquid cooling or solid-state cooling. In some embodiments, an immersion cooling system or a boiler tank of an immersion cooling system uses atmospheric cooling to dissipate heat from the cooling fluid. In some embodiments, the liquid cooling fluid can provide efficient heat transfer from heat-generating components with different or varying topographies, while the cooling fluid itself transfers the heat to fins, heat pipes, vapor chambers, heat sinks, or other passive cooling devices to be cooled by atmospheric cooling.

In some embodiments, the boiler tank of the immersion cooling system has a passive cooling device affixed thereto. In some embodiments, the passive cooling device includes heat fins to conduct heat from the boiler tank and to increase surface area exposure to the ambient air and remove heat from the boiler tank. In some embodiments, the passive cooling device includes a heat pipe or vapor chamber to disperse and/or conduct heat from the boiler tank to another area or to increase surface area exposure to the ambient air and remove heat from the boiler tank. In some embodiments, the passive cooling device is used in conjunction with or in addition to an active cooling device.

In some embodiments, boiling cooling fluid and the associated increase in vapor in the boiler tank increases that vapor pressure in the boiler tank. As the condenser or other cooling device cools the vapor to condense the vapor phase back into the liquid phase, the boiler tank may need to sustain increased vapor pressure without rupturing. In some embodiments, the boiler tank can sustain at least 2.0 atmospheres of internal vapor pressure. In some embodiments, the boiler tank can sustain at least 3.0 atmospheres of internal vapor pressure. In some embodiments, the boiler tank can sustain at least 4.0 atmospheres of internal vapor pressure.

To enhance boiling and facilitate return of the cooling fluid to the boiling surface, some embodiments of boiler tanks according to the present disclosure include wicking or boiling enhancement structures located inside the boiler tank in the immersion chamber. In some embodiments, the wicking structure includes an open lattice structure such as sintered copper powder or wire mesh that can enhance boiling efficiency and drive fluid back to the boiling surface using capillary action. In some embodiments, surface etching or boiling enhancement coatings can be applied to the boiling surface to create nucleation sites that enhance boiling efficiency.

In at least some embodiments of the present disclosure, an immersion cooling system that uses a boiler tank applied to a heat-generating component or a portion of a board of a computing device provides targeting high efficiency cooling to reduce costs and infrastructure limitations associated with large immersion tanks. Immersion cooling systems according to the present disclosure can improve modularity and reduce costs relative to conventional systems.

The present disclosure relates to systems and methods for improving the thermal management of high heat-generation components.

## Claims

1. A computer system (522; 622; 722) having thermal management, the system comprising: a boiler tank (220; 310; 420; 520; 620; 720-1, 720-2; 820) having a length (530), width (532), and height (534);
a first computer component (214; 314-1; 514; 614; 714-1, 714-2; 814) on a substrate (218; 322; 418) in the boiler tank;
a second computer component (314-2; 514; 614; 714-1, 714-2) on the substrate in the boiler tank;
a cooling fluid (204; 304; 808) positioned in the boiler tank and covering the first computer component; and
at least one computer component on the substrate that is not covered by a boiler tank,
wherein the length (530) and the width (532) of the boiler tank define a tank area that is no more than 50% of a substrate area;
wherein the boiler tank has nucleation sites on a surface thereof that promote the nucleation of vapor bubbles of the cooling fluid at or below the boiling temperature of the cooling fluid, wherein the nucleation sites comprise surface etching or boiling enhancement coatings.

2. The system of claim 1, wherein the first computer component and the second computer component are part of a multi-chip module.

3. The system of claim 2, wherein the first computer component and the second computer component are different heights above a surface of the substrate.

4. The system of any preceding claim further comprising a condenser (106; 606) positioned in the boiler tank and outside of a liquid phase of the cooling fluid.

5. The system of any preceding claim further comprising an external condenser (606; 706) positioned outside of the boiler tank and in fluid communication with the boiler tank (720-1, 720-2).

6. The system of claims 4 or 5, wherein the condenser is a liquid-cooled condenser.

7. The system of any preceding claim, further comprising a wicking structure (846) positioned in the boiler tank (820) and within a vapor phase (810) of the cooling fluid (808).

8. The system of any preceding claim, wherein the cooling fluid contacts the first computer component and the second computer component directly with no thermal interface material therebetween.

9. The system of any preceding claim further comprising an atmospheric heat sink (844) coupled to the boiler tank.

10. The system of any preceding claim, wherein the boiler tank can sustain at least 2.0 atmospheres of vapor pressure.

11. The system of any preceding claim, wherein the substrate is at least part of a bottom of the boiler tank.

12. A server computer system having thermal management, the system comprising:
a server substrate having a plurality of computer components thereon; a first boiler tank that encloses at least two computer components of the plurality of computer components;
a cooling fluid positioned in the first boiler tank and covering the at least one computer component of the plurality of computer components; and
at least one other computer component of the plurality of computer components that is not covered by a boiler tank,
wherein a total boiler area is no more than 90% of a substrate area of the server substrate;
wherein the boiler tank has nucleation sites on a surface thereof that promote the nucleation of vapor bubbles of the cooling fluid at or below the boiling temperature of the cooling fluid, wherein the nucleation sites comprise surface etching or boiling enhancement coatings.

## Patentansprüche

1. Computersystem (522; 622; 722), das Wärmeverwaltung aufweist, wobei das System umfasst:
einen Boilertank (220; 310; 420; 520; 620; 720-1, 720-2; 820), der eine Länge (530), eine Breite (532) und eine Höhe (534) aufweist;
eine erste Computerkomponente (214; 314-1; 514; 614; 714-1, 714-2; 814) auf einem Substrat (218; 322; 418) im Boilertank;
eine zweite Computerkomponente (314-2; 514; 614; 714-1, 714-2) auf dem Substrat im Boilertank;
eine Kühlflüssigkeit (204; 304; 808), die im Boilertank positioniert ist und die erste Computerkomponente bedeckt; und
mindestens eine Computerkomponente auf dem Substrat, die nicht von einem Boilertank bedeckt ist,
wobei die Länge (530) und die Breite (532) des Boilertanks eine Tankfläche definieren, die nicht mehr als 50 % einer Substratfläche beträgt;
wobei der Boilertank auf einer seiner Oberflächen Keimbildungsstellen aufweist, die die Keimbildung von Dampfblasen der Kühlflüssigkeit bei oder unterhalb der Siedetemperatur der Kühlflüssigkeit fördern, wobei die Keimbildungsstellen Oberflächenätzungen oder Beschichtungen zur Verbesserung des Siedens umfassen.

2. System nach Anspruch 1, wobei die erste Computerkomponente und die zweite Computerkomponente Teil eines Mehrchipmoduls sind.

3. System nach Anspruch 2, wobei die erste Computerkomponente und die zweite Computerkomponente sich in unterschiedlicher Höhe über einer Oberfläche des Substrats befinden.

4. System nach einem der vorhergehenden Ansprüche, ferner umfassend einen Kondensator (106; 606), der im Boilertank und außerhalb einer flüssigen Phase der Kühlflüssigkeit positioniert ist.

5. System nach einem der vorhergehenden Ansprüche, ferner umfassend einen externen Kondensator (606; 706), der außerhalb des Boilertanks positioniert ist und in Fluidverbindung mit dem Boilertank (720-1, 720-2) steht.

6. System nach Anspruch 4 oder 5, wobei der Kondensator ein flüssigkeitsgekühlter Kondensator ist.

7. System nach einem der vorhergehenden Ansprüche, ferner umfassend eine Dochtstruktur (846), die in dem Boilertank (820) und innerhalb einer Dampfphase (810) der Kühlflüssigkeit (808) positioniert ist.

8. System nach einem der vorhergehenden Ansprüche, wobei die Kühlflüssigkeit die erste Computerkomponente und die zweite Computerkomponente direkt ohne Wärmeschnittstellenmaterial dazwischen berührt.

9. System nach einem der vorhergehenden Ansprüche, ferner umfassend eine atmosphärische Wärmesenke (844), die mit dem Boilertank gekoppelt ist.

10. System nach einem der vorhergehenden Ansprüche, wobei der Boilertank mindestens 2,0 Atmosphären Dampfdruck aushalten kann.

11. System nach einem der vorhergehenden Ansprüche, wobei das Substrat mindestens Teil eines Bodens des Boilertanks ist.

12. Servercomputersystem, das Wärmeverwaltung aufweist, wobei das System umfasst:
ein Serversubstrat mit einer Vielzahl von Computerkomponenten darauf; einen ersten Boilertank, der mindestens zwei Computerkomponenten der Vielzahl von Computerkomponenten umschließt;
eine Kühlflüssigkeit, die in dem ersten Boilertank positioniert ist und die mindestens eine Computerkomponente der Vielzahl von Computerkomponenten bedeckt; und
mindestens eine andere Computerkomponente der Vielzahl von Computerkomponenten, die nicht von einem Boilertank bedeckt ist,
wobei eine Gesamtboilerfläche nicht mehr als 90 % einer Substratfläche des Serversubstrats beträgt;
wobei der Boilertank auf einer seiner Oberflächen Keimbildungsstellen aufweist, die die Keimbildung von Dampfblasen der Kühlflüssigkeit bei oder unterhalb der Siedetemperatur der Kühlflüssigkeit fördern, wobei die Keimbildungsstellen Oberflächenätzungen oder Beschichtungen zur Verbesserung des Siedens umfassen.

## Revendications

1. Système informatique (522 ; 622 ; 722) à gestion thermique, le système comprenant :
un réservoir de chaudière (220 ; 310 ; 420 ; 520 ; 620 ; 720-1, 720-2 ; 820) ayant une longueur (530), une largeur (532) et une hauteur (534) ;
un premier composant informatique (214 ; 314-1 ; 514 ; 614 ; 714-1, 714-2 ; 814) sur un substrat (218 ; 322 ; 418) du réservoir de chaudière ;
un second composant informatique (314-2 ; 514 ; 614 ; 714-1, 714-2) sur le substrat du réservoir de chaudière ;
un fluide de refroidissement (204 ; 304 ; 808) positionné dans le réservoir de chaudière et recouvrant le premier composant informatique ; et
au moins un composant informatique sur le substrat et non recouvert par un réservoir de chaudière,
dans lequel la longueur (530) et la largeur (532) du réservoir de chaudière définissent l'aire de réservoir représentant au plus 50 % de l'aire de substrat ;
dans lequel le réservoir de chaudière comporte des sites de nucléation sur une surface de celui-ci, lesquels favorisent la nucléation de bulles de vapeur du fluide de refroidissement à une température inférieure ou égale à la température d'ébullition du fluide de refroidissement, dans lequel les sites de nucléation comprennent des revêtements de gravure superficielle ou d'amélioration de l'ébullition.

2. Système selon la revendication 1, dans lequel le premier composant informatique et le second composant informatique font partie d'un module multipuce.

3. Système selon la revendication 2, dans lequel le premier composant informatique et le second composant informatique sont à des hauteurs différentes au-dessus d'une surface du substrat.

4. Système selon l'une quelconque des revendications précédentes comprenant en outre un condenseur (106 ; 606) positionné dans le réservoir de chaudière et à l'extérieur d'une phase liquide du fluide de refroidissement.

5. Système selon l'une quelconque des revendications précédentes, comprenant en outre un condenseur externe (606 ; 706) positionné à l'extérieur du réservoir de chaudière et en communication fluidique avec le réservoir de chaudière (720-1, 720-2).

6. Système selon les revendications 4 ou 5, dans lequel le condenseur est un condenseur refroidi par un liquide.

7. Système selon l'une quelconque des revendications précédentes, comprenant en outre une structure de mèche (846) positionnée dans le réservoir de chaudière (820) et dans une phase vapeur (810) du fluide de refroidissement (808).

8. Système selon l'une quelconque des revendications précédentes, dans lequel le fluide de refroidissement entre en contact direct avec le premier composant informatique et avec le second composant informatique sans aucun matériau d'interface thermique entre eux.

9. Système selon l'une quelconque des revendications précédentes comprenant en outre un dissipateur thermique atmosphérique (844) accouplé au réservoir de chaudière.

10. Système selon l'une quelconque des revendications précédentes, dans lequel le réservoir de chaudière peut supporter au moins 2,0 atmosphères de pression de vapeur.

11. Système selon l'une quelconque des revendications précédentes, dans lequel le substrat constitue au moins une partie d'un fond du réservoir de chaudière.

12. Système informatique de serveur à gestion thermique, le système comprenant :
un substrat de serveur comportant une pluralité de composants informatiques ; un premier réservoir de chaudière qui renferme au moins deux composants informatiques de la pluralité de composants informatiques ;
un fluide de refroidissement, positionné dans le premier réservoir de chaudière et recouvrant l'au moins un composant informatique de la pluralité de composants informatiques ; et
au moins un autre composant informatique de la pluralité de composants informatiques et non recouvert par un réservoir de chaudière,
dans lequel l'aire totale de chaudière représente au plus 90 % de l'aire de substrat du substrat de serveur ;
dans lequel le réservoir de chaudière comporte des sites de nucléation sur une surface de celui-ci, lesquels favorisent la nucléation de bulles de vapeur du fluide de refroidissement à une température inférieure ou égale à la température d'ébullition du fluide de refroidissement, dans lequel les sites de nucléation comprennent des revêtements de gravure superficielle ou d'amélioration de l'ébullition.
